# EUROPÄISCHE PATENTANMELDUNG

(11) **EP 1 179 849 A2**
(43) Veröffentlichungstag der Anmeldung: **13.02.2002**
(21) Anmeldenummer: 01117855.5
(22) Anmeldetag: 23.07.2001
(51) Int. Cl.: H01L 27/115, H01L 21/8246

(54) **Speicherzelle und Herstellungsverfahren**

(30) Priorität: 09.08.2000 DE 10038877
(71) Anmelder: Infineon Technologies AG, 81669 München (DE)
(72) Erfinder: Willer, Josef, Dr., 85521 Riemerling (DE)
(74) Vertreter: Epping Hermann & Fischer

(57) **Zusammenfassung**

Die durch STI-Gräben voneinander isolierten Speicherzellen besitzen jeweils eine ONO-Schichtstruktur zwischen einer Gate-Elektrode (5) und dem in dem Halbleiterkörper (1) ausgebildeten Kanalbereich. Die Gate-Elektrode ist Anteil einer streifenförmigen Wortleitung (6). Zwischen den Gate-Elektroden benachbarter Speicherzellen sind Source- und Drain-Bereiche vorhanden. Die Source-Bereiche (S) sind mit streifenförmigen Polysiliziumschichten (17) als gemeinsamen Source-Leitungen versehen; die Drain-Bereiche (D) sind über Polysiliziumfüllungen mit auf der Oberseite aufgebrachten metallischen Leiterbahnen (23) als Bitleitungen verbunden.

## Beschreibung

Die vorliegende Erfindung betrifft eine elektrisch beschreib-bare und löschbare nicht-flüchtige Flash-Speicherzelle, die als SONOS-Zelle (semiconductor oxide nitride oxide semiconductor) aufgebaut ist. Außerdem wird ein zugehöriges Herstellungsverfahren angegeben.

Ein Ziel der Entwicklung von Speicherbausteinen ist es, eine möglichst kleine Speicherzellenanordnung anzugeben, die aber dennoch einen schnellen wahlfreien Zugriff auf einzelne Speicherplätze erlaubt. Eine solche Speicherzellenanordnung soll nach Möglichkeit im Rahmen üblicher Herstellungstechnologien, insbesondere für die in der Ansteuerperipherie vorgesehenen elektronischen Bauelemente, realisierbar sein.

Kleinste nicht-flüchtige Speicherzellen werden für höchste Integrationsdichten bei Multimedia-Anwendungen benötigt. Bisher werden hauptsächlich Floating-Gate-Flash-Zellen in NAND-, AND- oder Virtual-Ground-NOR-Architektur eingesetzt, wobei die kleinsten aus Produkten bekannten Speicherzellen eine Fläche von 5F² aufweisen. Die Virtual-Ground-Anordnung gestattet aber nicht einen schnellen Random-Read-Access, der eine niederohmige (metallische) Bitleitung bis zur einzelnen Speicherzelle erfordert. Standard-T-Shape-Zellen mit metallischem Anschluss erfordern wegen der notwendigen Justierabstände eine deutlich größere Zellenfläche; heute sind solche Floating-gate-Zellen mit 12F² üblich.

In der Veröffentlichung von H. Aozasa et al.: "Analysis of Carrier Traps in Si₃N₄ in Oxide/Nitride/Oxide for Metal/Oxide/Nitride/Oxide/Silicon Nonvolatile Memory" in Jpn. J. Appl. Phys. 38, 1441-1447 (1999) ist eine Speicherschichtstruktur auf der Grundlage einer Oxid-Nitrid-Oxid-Schichtfolge beschrieben und untersucht.

In der US 5,397,726 ist ein Flash-EPROM beschrieben, bei dem die Speicherschichtstruktur zwischen dem Halbleiterkörper und der Gate-Elektrode angeordnet ist, die Source-Leitung als gemeinsamer Source-Anschluss für mehrere Speicherzellen vorgesehen ist und eine Floating-Gate-Elektrode als Speicherschicht vorgesehen ist.

In der US 6,080,624 ist ein nichtflüchtiger Halbleiterspeicher beschrieben, bei dem eine als Speicherschicht vorgesehene Floating-Gate-Elektrode zwischen einem Gate-Dielektrikum und einer ONO-Schicht angeordnet ist.

Aus der US 5,918,124 ist eine Ausbildung von Distanzelementen für LDD-Source-/Drainbereiche bei einer Mehrfach-Speicher-EEPROM-Zelle zu entnehmen.

Aufgabe der vorliegenden Erfindung ist es, eine nicht-flüchtige Speicherzelle für höchste Integrationsdichte mit kurzen Zugriffszeiten und ein zugehöriges Herstellungsverfahren anzugeben.

Diese Aufgabe wird mit der Speicherzelle mit den Merkmalen des Anspruches 1 bzw. mit dem Herstellungsverfahren mit den Merkmalen des Anspruches 15 gelöst. Ausgestaltungen ergeben sich aus den abhängigen Ansprüchen.

Die erfindungsgemäße Speicherzelle besitzt eine ONO-Schichtstruktur oder eine gleichwertige Speicherschichtstruktur zwischen einer Gate-Elektrode und dem in dem Halbleiterkörper ausgebildeten Kanalbereich. Die Gate-Elektrode ist Anteil einer streifenförmigen Wortleitung. Zwischen den Gate-Elektroden benachbarter Speicherzellen sind Source- und Drain-Bereiche vorhanden. Die Source-Bereiche sind mit streifenförmigen Polysiliziumschichten versehen, die zwischen den Gate-Elektroden angeschlossen sind, um gemeinsame Source-Leitungen zu realisieren. Die Drain-Bereiche sind über Polysiliziumfüllungen mit auf der Oberseite aufgebrachten metallischen Leiterbahnen als Bitleitungen verbunden. In der Richtung quer zu der Abfolge von Source-Bereich, Gate-Elektrode und Drain-Bereich werden die einzelnen Zellen einer Speicherzellenanordnung durch schmale Isolationsgräben (STI, shallow trench isolation) voneinander isoliert. Ein bevorzugtes Herstellungsverfahren ist in besonderer Weise geeignet, in einen Herstellungsprozess integriert zu werden, mit dem zusammen mit der Speicherzellenanordnung auch die elektronischen Ansteuerbauelemente in der Peripherie des Speichers hergestellt werden.

In der Speicherschichtstruktur ist die eigentliche Speicherschicht zwischen Begrenzungsschichten angeordnet und so in Material einer höheren Energiebandlücke eingebettet, dass die Ladungsträger, die in der Speicherschicht jeweils über dem Source-Bereich und über dem Drain-Bereich eingefangen sind, dort lokalisiert bleiben. Als Material für die Speicherschicht kommt vorzugsweise ein Nitrid in Frage; als umgebendes Material ist vorrangig ein Oxid geeignet. Bei einer Speicherzelle im Materialsystem von Silizium ist die Speicherzelle in diesem Beispiel Siliziumnitrid mit einer Energiebandlücke von etwa 5 eV, die umgebenden Begrenzungsschichten Siliziumoxid mit einer Energiebandlücke von etwa 9 eV. Die Speicherschicht kann ein anderes Material mit einer kleineren Energiebandlücke als derjenigen der Begrenzungsschichten sein, wobei die Differenz der Energiebandlücken für einen guten elektrischen Einschluss der Ladungsträger (confinement) möglichst groß sein soll. In Verbindung mit Siliziumoxid kann so z. B. Tantaloxid, Hafniumsilikat oder intrinsisch leitendes (undotiertes) Silizium als Material der Speicherschicht eingesetzt werden. Die Speicherschicht kann in bevorzugten Ausführungen auch speziell Hafniumoxid oder Hafniumsilikat oder Zirkonoxid oder Zirkonsilikat enthalten, und die Begrenzungsschichten können Aluminiumoxid oder aluminiumhaltiges Siliziumoxid sein. Siliziumnitrid besitzt eine relative Dielektrizitätszahl von etwa 7,9. Die Verwendung eines alternativen Materials mit einer höheren Dielektrizitätszahl (z. B. ≈ 15 ... 18) gestattet eine Verringerung der Gesamtdicke des für die Speicherung vorgesehenen Schichtstapels und ist daher von Vorteil.

Es folgt eine genauere Beschreibung bevorzugter Ausführungsbeispiele der Speicherzelle anhand der in den Figuren erläuterten Herstellungsverfahren.
Die Figuren 1 bis 4 und 6 zeigen Querschnitte durch Zwischenprodukte nach verschiedenen Schritten des Herstellungsverfahrens.
Die Figuren 5 und 7 zeigen Zwischenprodukte des Herstellungsverfahrens in Aufsicht.
Die Figuren 8 und 9 zeigen Querschnitte durch eine im Wesentlichen fertiggestellte Speicherzellenanordnung.

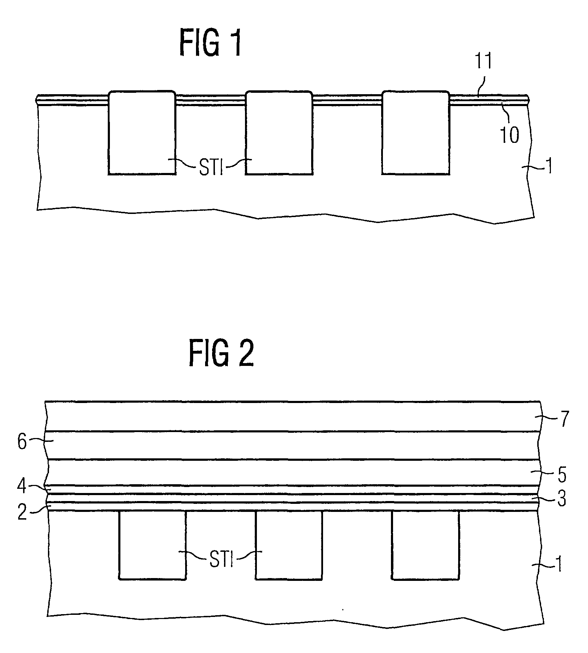

Die einzelnen Bestandteile der erfindungsgemäßen Speicherzelle sollen im Folgenden der Klarheit halber anhand der Prozessschritte eines bevorzugten Herstellungsverfahrens erläutert werden. In Figur 1 ist im Querschnitt ein Halbleiterkörper 1 dargestellt, der ein Substrat aus Halbleitermaterial oder ein mit epitaktisch aufgewachsenen Schichten versehenes Substrat sein kann. Besonders geeignet ist dafür Halbleitermaterial, das p-leitend dotiert ist. Die Prozessschritte zur Herstellung der Speicherzellen erfolgen vorzugsweise parallel zu den Prozessschritten, mit denen die elektronischen Bauelemente der für die Ansteuerung des Speichers vorgesehenen elektronischen Schaltung hergestellt werden. Falls es sich dabei um Transistoren einer im Rahmen eines CMOS-Prozesses hergestellten Schaltung handelt, beginnt der Prozess vorzugsweise wie üblich mit dem Aufbringen einer als Padoxid vorgesehenen vorläufigen Oxidschicht 10 auf die Oberseite des Halbleiterkörpers 1 und einem nachfolgenden Aufbringen einer als Padnitrid vorgesehenen vorläufigen Nitridschicht 11 auf diese Oxidschicht 10. Das Padnitrid wird typisch in einer Dicke von etwa 150 nm als Ätzstopp und/oder Polierstopp aufgebracht. Mittels einer Fototechnik werden dann unter Verwendung einer Maske, die z. B. ein üblicherweise verwendeter Fotolack sein kann, geradlinig parallel im Abstand zueinander verlaufende Gräben in die mit dem Padoxid und dem Padnitrid versehene Oberseite des Halbleiterkörpers geätzt. Nach dem Entfernen der Maske werden die geätzten Gräben mit einem elektrisch isolierenden Oxid gefüllt. Auf diese Weise werden die in Figur 1 dargestellten Isolationsgräben STI (shallow trench isolation) hergestellt. Die Höhe der vorläufigen Nitridschicht 11 und ein während der nachfolgenden Prozessschritte unvermeidbares Schrumpfen des in die Gräben eingebrachten Materials werden berücksichtigt, damit die Füllung der Gräben, wie in Figur 1 dargestellt, in so ausreichender Menge vorhanden ist, insbesondere etwas über die Oberseite des Halbleiterkörpers hinausragt, dass die Oberseite anschließend planarisiert werden kann. Die vorläufige Nitridschicht 11 wird nasschemisch entfernt. Es werden auf dem Halbleiterkörper für weitere Prozessschritte erforderliche Marken zur Orientierung der Masken hergestellt. Diese Prozessschritte sind an sich nicht erfindungswesentlich und erfolgen wie üblich im Rahmen des CMOS-Prozesses.

Zu den ohnehin durchgeführten Prozessschritten gehört auch das Aufbringen eines Streuoxids (sacrificial oxide), das gesondert aufgebracht werden kann, nachdem die vorläufige Oxidschicht 10 entfernt wurde, oder für das bereits diese vorläufige Oxidschicht 10 verwendet werden kann. Es werden dann sowohl die für die Ansteuertransistoren als auch die für die Speicherzellen verwendeten Wannen hergestellt, indem in den Halbleiterkörper Dotierstoff für die betreffende elektrische Leitfähigkeit in einer spezifizierten Konzentration implantiert wird. Bei Verwendung eines p-leitend dotierten Siliziumsubstrates werden die für die Speicherzellen vorgesehenen p-Wannen durch Einbringen von Bor hergestellt. Für die entgegengesetzt dotierten Transistoren der CMOS-Schaltungen werden entsprechend n-Wannen durch Einbringen von Phosphor oder Arsen als Dotierstoff hergestellt. Das Streuoxid wird dann entfernt, was auch wieder nasschemisch geschehen kann, so dass ein mit Isolationsgräben und Wannen präparierter Halbleiterkörper mit einer ausreichend schonend behandelten Oberfläche erhalten wird.

Gemäß dem in Figur 2 dargestellten Querschnitt können auf den so vorbereiteten Halbleiterkörper die Schichten der Speicherschichtstruktur, insbesondere bei einer ONO-Schichtstruktur die folgenden Schichten übereinander aufgebracht werden: zunächst eine erste Oxidschicht 2 als Bottom-oxide (untere Begrenzungsschicht), die vorzugsweise eine Dicke von typisch 2,5 nm bis 8 nm aufweist, eine als eigentliches Speichermedium vorgesehene Speichernitridschicht 3 (Speicherschicht), die vorzugsweise mittels LPCVD (low pressure chemical vapor deposition) in einer Dicke von 1 nm bis 5 nm aufgebracht wird, eine zweite Oxidschicht 4 als Top-oxide (obere Begrenzungsschicht), die eine Dicke von typisch 3 nm bis 9 nm, auch bis 12 nm, aufweist, eine elektrisch leitend dotierte Polysiliziumschicht 5, mindestens eine metallhaltige Schicht 6, die als Zuleitung zur Gate-Elektrode vorgesehen ist, und zuoberst eine Nitridschicht 7, die in nachfolgenden Schritten strukturiert wird und als Hartmaske dient.

Zusätzlich zu dem Aufbringen dieser für die Speicherzellen vorgesehenen Schichtfolge werden auch die für die Ansteuerkomponenten erforderlichen Schichten aufgebracht. Das kann z. B. nach dem Aufbringen der zweiten Oxidschicht 4 und vor dem Aufbringen der Polysiliziumschicht erfolgen. Es wird dabei ein thermisches Oxid als Gate-Oxid für die CMOS-Transistoren der Peripherie aufgebracht. Für die Hochvolt-Transistoren besitzt diese Schicht eine Dicke von ca. 15 nm. Bei Bedarf kann dieser Verfahrensschritt wiederholt werden, um zusätzliche dünnere Oxidschichten als Gate-Oxid für Niedervolt-Transistoren herzustellen. Die in Figur 2 im Querschnitt dargestellte Schichtfolge umfasst eine metallhaltige Schicht 6, die z. B. ein Silizid, insbesondere Wolfram-Silizid, sein kann. Statt dessen kann diese Schicht 6 auch eine Doppelschicht aus einem Metallnitrid und einer reinen Metallschicht sein, z. B. Wolframnitrid und Wolfram.

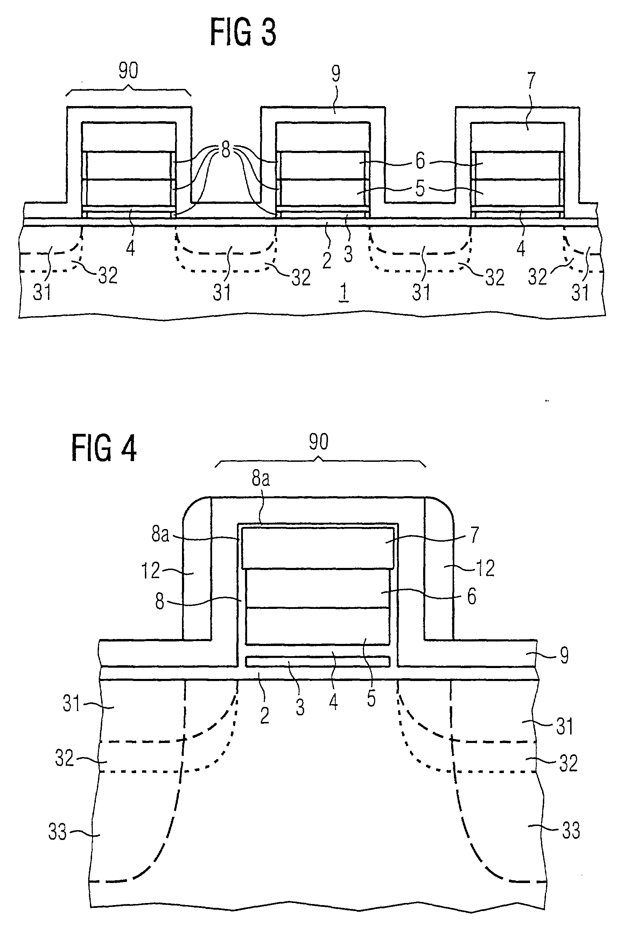

In Figur 3 ist ein Querschnitt dargestellt, der parallel zu den Isolationsgräben zwischen zwei Isolationsgräben gezogen ist. Die für die Gate-Elektrode vorgesehene Schichtfolge wird mittels einer Fototechnik in streifenförmige Anteile strukturiert. Das geschieht vorzugsweise dadurch, dass die Nitridschicht 7 mittels einer in mehrere parallele Streifen strukturierten Fotolackmaske gitterartig strukturiert wird. Die strukturierte Nitridschicht 7 wird dann als Hartmaske verwendet, um die übrigen Schichten in der in Figur 3 dargestellten Weise in parallel zueinander verlaufende Stege aus einem jeweiligen streifenartigen Anteil der Schichtfolge zu strukturieren. In diesem Verfahrensschritt wird bis auf die Speichernitridschicht 3 herab geätzt, wobei vorzugsweise auch diese Speichernitridschicht 3 mit entfernt wird. Es ergibt sich so die Strukturierung gemäß Figur 3.

Es empfiehlt sich, anschließend die Seitenwände der so erhaltenen streifenförmigen Anteile der Schichtfolge zu oxidieren. In Figur 3 sind diese dünnen Seitenwandoxidschichten 8 angedeutet. Bei dieser Oxidation wird auch die Nitridschicht 7 oberflächlich in einer sehr dünnen und daher in Figur 3 nicht eingezeichneten Schicht oxidiert, was jedenfalls für den Herstellungsprozess letztlich unerheblich ist. Eine typische Dicke der Seitenwandoxidschicht 8 liegt bei etwa 6 nm.

Es werden dann Implantationen eingebracht, mit denen n-LDD-Bereiche (lightly doped drain) und p-LDD-Bereiche einschließlich einer zugehörigen, an sich bekannten Pocket-Implantation des jeweils entgegengesetzten Vorzeichens für die Ansteuerbauelemente der Peripherie hergestellt werden. Es wird dann im Fall eines p-leitend dotierten Halbleiterkörpers bzw. einer für die Speicherzellen hergestellten p-dotierten Wanne eine entsprechende n-Implantation 31 zur Ausbildung der für die Speicherzellen vorgesehenen LDD-Bereiche und eine p-Implantation 32 als Pocket-Implantation eingebracht.

Daran anschließend erfolgt eine ganzflächige Abscheidung einer weiteren Nitridschicht 9 mit einer Dicke von typisch etwa 10 nm. Die oberen Kanten der streifenförmigen Anteile der Schichtfolge, die - anders als in der idealisierenden Darstellung der Figur 3 - abgerundet sein können, besitzen dann jeweils einen Abstand 90 zueinander, der in den nachfolgenden Figuren zur Verdeutlichung mit eingezeichnet ist. Als Folge der zuvor vorgenommenen Seitenwandoxidation sind die verbliebenen Anteile der Speichernitridschicht 3 durch schmale seitliche Oxidstreifen von der weiteren Nitridschicht 9 getrennt, also ringsum in Oxid eingebettet.

In Figur 4 ist der Bereich um eine Gate-Elektrode größer dargestellt. Die Bezeichnungen der Anteile mit Bezugszeichen entspricht den Bezeichnungen aus Figur 3. Eine sehr dünne Oxidationsschicht auf der Nitridschicht 7 ist hier als Oxidschicht 8a eingezeichnet. Es ist hier deutlich erkennbar, dass die Speichernitridschicht 3 ringsum von Oxid umgeben ist. Beidseitig an den vertikalen Anteilen der Nitridschicht 9 werden Distanzelemente 12 (spacer) hergestellt. Das geschieht in der an sich bekannten Weise dadurch, dass eine Schicht aus dem für die Distanzelemente vorgesehenen Material, üblicherweise einem Oxid, zunächst isotrop ganzflächig aufgebracht wird. Eine anisotrope Rückätzung entfernt dann die horizontal aufgebrachten Anteile der Schicht, während in der seitlichen Richtung nur wenig Material abgetragen wird. Es bleiben so die Distanzelemente 12 in etwa der eingezeichneten Querschnittsform übrig.

Die Distanzelemente, die eine Breite (Schichtdicke) von typisch etwa 10 nm aufweisen, dienen nachfolgend dazu, eine Implantation von Dotierstoff 33 für die Source- und Drain-Bereiche herzustellen. Dabei schirmen die Distanzelemente 12 die als LDD-Bereiche vorgesehenen Bereiche ab, so dass seitlich zu den eigentlichen Source- und Drain-Bereichen solche LDD-Bereiche niedrigerer Dotierstoffkonzentration verbleiben. Alternativ kann der Dotierstoff auch durch Ausdiffusion aus der später aufgebrachten Schicht aus Polysilizium eingebracht werden. In diesem Verfahrensschritt werden auch die entsprechenden Implantationen bei den Bauelementen der Peripherie vorgenommen.

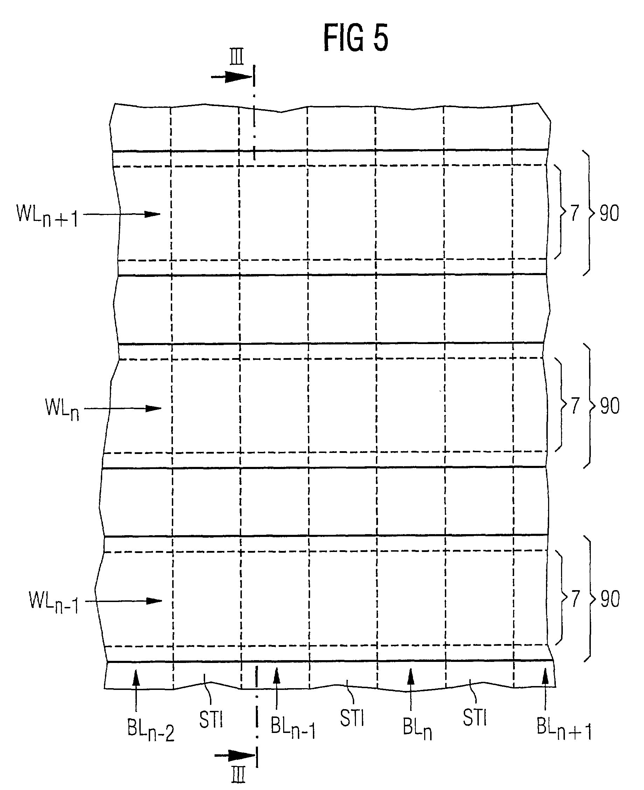

Figur 5 zeigt die Anordnung der Isolationsgräben STI und der streifenförmigen Anteile der Schichtfolge in Aufsicht vor der Herstellung der Distanzelemente 12, also entsprechend dem in Figur 3 dargestellten Querschnitt, dessen Schnittlinie in Figur 5 eingezeichnet ist. Die Bereiche zwischen den Isolationsgräben sind für die Anordnung der Bitleitungen BLₙ vorgesehen. Die Wortleitungen WLₙ werden durch die metallhaltigen Schichten 6 der streifenförmigen Anteile der Schichtfolge, die die Gate-Elektroden miteinander verbinden, gebildet. Die Oberfläche, die in Figur 5 in Aufsicht dargestellt ist, wird von der weiteren Nitridschicht 9 bedeckt. Die seitlichen Berandungen der darunter vorhandenen Nitridschicht 7 sind als verdeckte Konturen gestrichelt eingezeichnet. Ebenso sind die Verläufe der Isolationsgräben als verdeckte Konturen mit senkrecht dazu verlaufenden gestrichelten Geraden eingezeichnet.

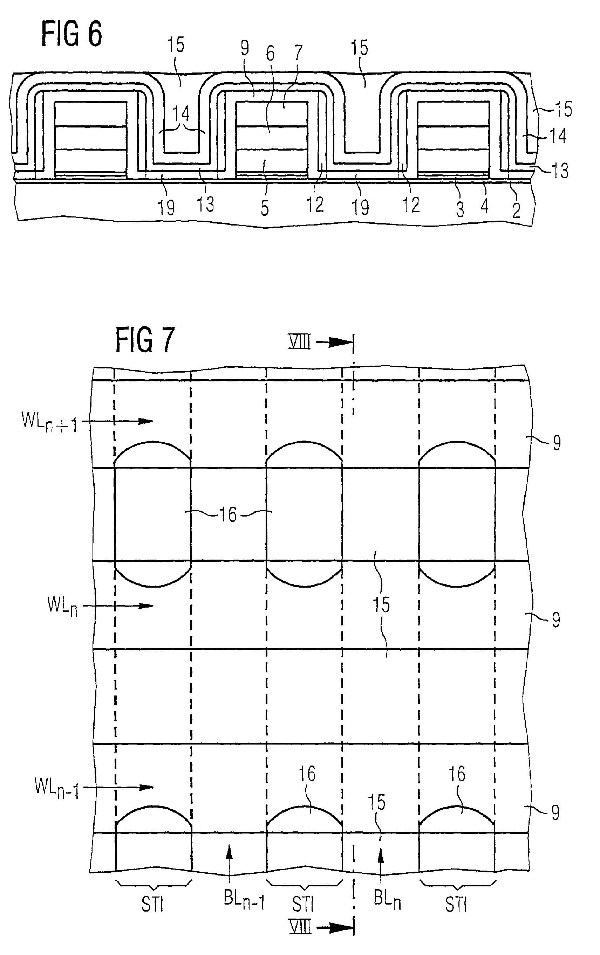

Die Bereiche zwischen den streifenförmigen Anteilen der Schichtfolge werden dann mit einem elektrisch isolierenden Material aufgefüllt. Das kann auf verschiedene Weise geschehen. Zunächst ist es möglich, noch einmal Nitrid auf die weitere Nitridschicht 9 abzuscheiden. Das ist im Querschnitt der Figur 6 durch die ergänzende Nitridschicht 13 dargestellt. Anschließend wird das eigentliche für das Auffüllen der Zwischenräume vorgesehene elektrisch isolierende Material eingebracht. Das ist z. B. Siliziumdioxid. Es genügt dabei, wenn zunächst nur die in Figur 6 eingezeichnete SiO₂-Schicht 14 abgeschieden und das restliche noch aufzufüllende Volumen mit einer BPSG-Füllung 15 (Borphosphorsilikatglas) gefüllt wird. Dieses BPSG ist im Grunde ein spezielles Siliziumoxid, das mit Bor- und Phosphoratomen dotiert ist, ohne dass damit eine elektrische Leitfähigkeit bewirkt wird. BPSG wird bei der Herstellung von Halbleiterbauelementen vielfach eingesetzt, um eine bereits passivierte, aber noch nicht planarisierte Oberfläche eines mit Schaltungskomponenten versehenen Halbleiterchips einzuebnen und so eine Basis für aufzubringende Zwischenmetalldielektrika und verschiedene Leiterbahnebenen zu bilden.

Es kann bei der Herstellung der Speicherzelle auch darauf verzichtet werden, zunächst die Siliziumdioxidschicht 14 einzubringen, wenn die gesamte Füllung aus BPSG gebildet wird. Bei der hier beschriebenen Variante des Verfahrens werden die Distanzelemente 12 aus einem Material hergestellt, bezüglich dessen die Füllungen der Zwischenräume selektiv entfernt werden können. Als solches Material eignet sich insbesondere Oxinitrid, das beim Entfernen von Siliziumdioxid und BPSG einen Ätzstopp bildet. Daher können in den Bereichen, in denen nachfolgend die Füllungen der Zwischenräume zwischen den streifenförmigen Anteilen der Schichtfolge entfernt werden, unter Verwendung der dann noch übrig gebliebenen Distanzelemente 12 die in Figur 6 eingezeichneten dazwischen vorhandenen Anteile 19 der weiteren Nitridschicht 9 entfernt werden. Falls, wie oben angegeben, die Distanzelemente 12 ein übliches Oxid sind, dieses Oxid also zusammen mit der Füllung der Zwischenräume entfernt wird, werden die in Figur 6 gestrichelt eingezeichneten Anteile 19 der weiteren Nitridschicht 9 vor dem Auffüllen der Zwischenräume weggeätzt. Auf ein nochmaliges Abscheiden von Nitrid (Schicht 13 in Figur 6) wird dann verzichtet, und es wird sofort das Siliziumdioxid der Schicht 14 bzw. die BPSG-Füllung 15 eingebracht. Bei beiden Ausführungsvarianten wird jedenfalls die Möglichkeit geschaffen, die weitere Nitridschicht 9 an denjenigen Bereichen der Oberseite des Halbleiterkörpers 1 zu entfernen, an denen die höher dotierten Source- und Drain-Bereiche ausgebildet sind, während die weitere Nitridschicht 9 weiterhin die LDD-Bereiche sowie die streifenförmigen Anteile der Schichtfolge bedeckt.

Figur 7 zeigt wieder eine Aufsicht auf die Oberfläche entsprechend der Blickrichtung von Figur 5. Die Zwischenräume zwischen den streifenförmigen Anteilen der Schichtfolge sind jetzt vollständig mit SiO₂ und/oder BPSG gefüllt. In diesem Beispiel wurde angenommen, dass die Füllungen zuoberst durch BPSG-Füllungen 15 gebildet sind, zwischen denen noch die Oberfläche der weiteren Nitridschicht 9 frei geblieben ist. Die Lage der Isolationsgräben STI ist auch hier wieder durch die gestrichelten Geraden als verdeckte Konturen bezeichnet. Ebenso sind die für die Bitleitungen BLₙ und die Wortleitungen WLₙ vorgesehenen Ausrichtungen mit Pfeilen bezeichnet. Auf die Oberseite werden Lackmasken 16 aufgebracht, die jeweils einen Bereich oberhalb eines jeweiligen Isolationsgrabens bedecken. Die in Figur 7 idealisierend gezeichnete Darstellung stellt dabei aber keine Einschränkung für die genauen seitlichen Begrenzungen dieser Lackmasken 16 dar. Die mit den Lackmasken 16 abgedeckten Bereiche können daher insbesondere die bezüglich der Schichtebenen senkrechte Projektion der Isolationsgräben seitlich überragen. Wesentlich bei der Anordnung der einzelnen Anteile der Lackmaske 16 ist dabei nur, dass das Material der Füllungen der Zwischenräume in den für die Bitleitungen vorgesehenen Bereichen über dem Halbleitermaterial entfernt werden kann. Das unter den Lackmasken verbleibende Material dient dann als elektrische Isolation zwischen aufeinanderfolgenden Speicherzellen der Anordnung. Es werden aber nicht alle Bereiche der Zwischenräume oberhalb der Isolationsgräben abgedeckt; auch Streifen zwischen zwei nebeneinander verlaufenden streifenförmigen Anteilen der Schichtfolge werden frei gelassen. Diese Bereiche dienen später zur Ausbildung gemeinsamer Source-Leitungen.

In Figur 7 sind in dem Ausschnitt sechs Anteile der Lackmaske 16 dargestellt; oben sind drei vollständige Anteile zu sehen, während die drei unteren Anteile durch die eingezeichneten Bruchlinien jeweils nach unten abgeschnitten sind. Zwischen den in Figur 7 oben und unten eingezeichneten Anteilen der Lackmaske 16 befindet sich ein solcher Bereich einer BPSG-Füllung 15, der von den Lackmasken auf seiner gesamten Länge frei gelassen ist. Die Füllung dieses Zwischenraumes kann daher auf der gesamten Länge der benachbarten Wortleitungen WLₙ₋₁ und WLₙ entfernt werden.

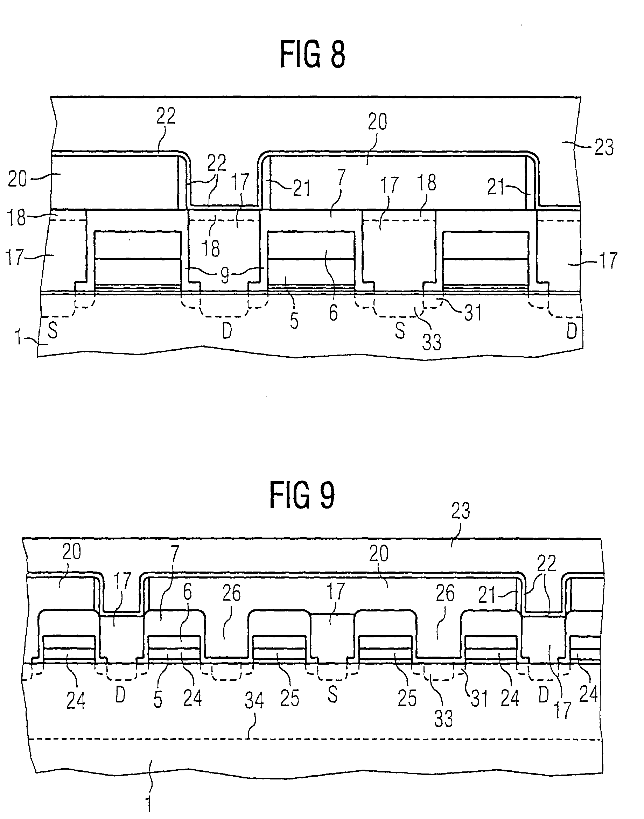

In Figur 8 ist ein Querschnitt dargestellt, in dessen unterem Teil die dem Querschnitt aus Figur 6 entsprechende Struktur dargestellt ist. Da die Nitridschicht 7 und die weitere Nitridschicht 9 aus demselben Material und vorzugsweise mit einem gleichartigen Herstellungsprozess hergestellt sind, ist hier zwischen diesen Schichten keine Kontur der Begrenzung eingezeichnet. Über einem jeweiligen Source-Bereich S und einem Drain-Bereich D ist die weitere Nitridschicht 9 jeweils entfernt. Ebenso sind die Füllungen der Zwischenräume einschließlich der Distanzelemente 12 in den von der Lackmaske 16 aus Figur 7 freigelassenen Bereichen entfernt. Diese geöffneten Volumina sind aufgefüllt mit einer elektrisch leitend dotierten Polysiliziumschicht 17, deren oberster Schichtanteil mit einem Metallsilizid 18 ausgebildet sein kann. Dieses Metallsilizid (z. B. Kobaltsilizid oder Titansilizid) dient der Reduzierung des sourceseitigen Zuleitungswiderstandes und kann nach der Planarisierung der Polysiliziumschicht 17 in einem Salicide-Verfahren selektiv auf den Anteilen der Polysiliziumschicht 17 erzeugt werden. Ein derartiges Verfahren ist an sich bekannt. Die Metallsilizidschicht 18 kann aber auch weggelassen sein.

Nach der Planarisierung der Oberseite wird eine Dielektrikumschicht 20 aufgebracht und strukturiert. Vor dem Abscheiden dieser Dielektrikumschicht kann eine weitere dünne Nitridschicht ganzflächig aufgebracht werden. Als Dielektrikum ist hier wieder BPSG verwendbar. Mittels einer weiteren Fototechnik werden oberhalb der Polysiliziumschicht jeweils über den mit der jeweiligen Bitleitung zu kontaktierenden Drain-Bereichen D Kontaktlöcher für den Anschluss der Bitleitung hergestellt. Um an diesen Stellen die Kontaktierung der Oberseite der Polysiliziumschicht 17 besser justieren zu können, können an den seitlichen Rändern der mit den Kontaktlöchern strukturierten Dielektrikumschicht 20 die eingezeichneten Distanzelemente 21 hergestellt werden. Die Oberfläche wird dann vorzugsweise in einer an sich bekannten Weise mit einer dünnen Metallnitridschicht 22 als Liner-Nitrid überzogen.

Dann kann das Material der Drain-Leitung 23, die als Bitleitung vorgesehen ist, abgeschieden werden. Dieses Material wird dabei in die Kontaktlöcher hinein abgeschieden und steht dann in elektrisch leitender Verbindung mit den jeweils dort vorhandenen Anteilen der ebenfalls leitenden Polysiliziumschicht 17, so dass die jeweiligen Drain-Bereiche D mit der Drain-Leitung 23 elektrisch leitend verbunden werden. Als Material für die Drain-Leitung 23 kommt bevorzugt eine übereinander abgeschiedene Schichtfolge aus einem Metall, einem Metallnitrid und einem weiteren Metall, das für die Leiterbahnen der Verdrahtungsebene verwendet wird, in Frage. Eine mögliche Schichtfolge besteht z. B. aus einer zunächst abgeschiedenen Schicht aus Titan, darauf einer Schicht aus Titannitrid und einer oberen Schicht aus Wolfram; eine mögliche Alternative ist die Schichtfolge aus Tantal, Tantalnitrid und zuoberst Kupfer.

Anschließend erfolgt eine Strukturierung der abgeschiedenen Schichten in parallel zueinander im Abstand zueinander verlaufende streifenförmige Anteile, die in der für die Bitleitungen BLₙ in Figur 7 eingezeichneten Richtung angeordnet sind. Es können dann in einer an sich bekannten Weise wie für die Bauelemente der Peripherie Zwischenmetalldielektrika sowie verschiedene Metallisierungsebenen für den elektrischen Anschluss und die Verdrahtung aufgebracht werden. Die Anteile der Polysiliziumschicht 17 bilden über den Source-Bereichen S jeweils durchgehende streifenförmige Anteile, wie das bereits im Zusammenhang mit der Form der in Figur 7 eingezeichneten Lackmaske 16 beschrieben wurde. Diese Anteile der Polysiliziumschicht 17 können daher als gemeinsamer Source-Anschluss aller benachbarter Speicherzellen verwendet werden (Masse-anschluss).

Die einzelnen Speicherzellen werden über die zu dem Drain-Bereich geführte Drain-Leitung 23 als Bitleitung und die zu der Gate-Elektrode 5 geführte metallhaltige streifenförmige Schicht 6 als Wortleitung adressiert. Das Speichern selbst geschieht in der von ONO-Strukturen an sich bekannten Weise dadurch, dass Elektronen aus der Gate-Elektrode ausdiffundieren und in der Speichernitridschicht 3 gehalten ("gefangen", "trapped") werden. Dazu genügt es jeweils, die für das Speichern der Zelle geeigneten Potenziale anzulegen, die sich von den für das Auslesen angelegten Potenzialen unterscheiden.

In Figur 9 ist eine andere mögliche Ausgestaltung der Speicherzellenanordnung dargestellt, bei der zusätzlich zu den Gate-Elektroden noch Auswahl-Gate-Elektroden (select gates) vorhanden sind. Zur Herstellung dieser Struktur wird in den Bereichen, die für die Auswahltransistoren vorgesehen sind, vorzugsweise in einem Verfahrensschritt, in dem das Gateoxid für die Ansteuerbauelemente der Peripherie hergestellt wird, die ONO-Schichtfolge mindestens so weit abgetragen, dass dort nur das Bottom-oxide übrig bleibt, das anschließend zu der als Gate-Oxid der Auswahltransistoren vorgesehenen Oxidschicht aufoxidiert wird. Alternativ kann auch das Bottom-oxide ganz entfernt werden; in diesem Fall wird gesondert eine weitere Oxidschicht als Gate-Oxid der Auswahltransistoren hergestellt. Außerdem wird die in Figur 7 dargestellte Lackmaske 16 so ausgebildet, dass in einer fortlaufenden Nummerierung der streifenförmigen Anteile der Schichtfolge das isolierende Material jeweils zwischen einem geradzahlig nummerierten Anteil und dem darauf folgenden ungeradzahlig nummerierten Anteil stehen gelassen wird. Damit bleiben die in Figur 9 mit 26 bezeichneten Zwischenräume mit dem SiO₂ und/oder BPSG gefüllt. Grundsätzlich ist es auch möglich, auch diese Füllungen zu entfernen und die sich dabei ergebenden Öffnungen mit dem Material der Dielektrikumschicht 20 zu füllen. Die angegebene Verwendung einer geeignet strukturierten Lackmaske 16 besitzt aber den Vorteil der einfacheren Prozessführung. Auf die dargestellte Weise werden so zwischen den benachbarten Source- und Drain-Bereichen jeweils mit einer Source-/Drain-Dotierung 33 versehene Bereiche ausgebildet, die keine eigene elektrische Zuleitung besitzen, sondern nach oben durch das isolierende Material in den Bereichen 26 bedeckt sind. Die in Figur 9 eingezeichneten Ansteuer-Gate-Elektroden 25 der Speichertransistoren werden so durch Auswahl-Gate-Elektroden 24 ergänzt, die über die dazwischen angeordneten Source-/Drain-Bereiche in Reihe hintereinander geschaltet sind, so dass die Auswahl-Gate-Elektroden 24 jeweils als Select-gates für eine blockweise Adressierung von Speicherzellen eingesetzt werden können. Die Anordnung von Ansteuer-Gate-Elektroden und Auswahl-Gate-Elektroden kann gegenüber der in der Figur 9 dargestellten Anordnung vertauscht sein, so dass die Anordnung von Speichertransistoren und Auswahltransistoren gegenüber der dargestellten Ausführungsform vertauscht ist. Das Select-gate kann also sowohl zwischen Speichertransistor und Bitleitungskontakt als auch zwischen Speichertransistor und gemeinsamer Sourceleitung angeordnet werden. In Figur 9 ist noch die durch die Wannen-Implantation eingebrachte, gegenüber der Grunddotierung des Halbleiterkörpers 1 eine höhere Dotierstoffkonzentration aufweisende Implantation 34 eingezeichnet.

Mit der vorliegenden Erfindung werden eine Struktur und ein Verfahren zur Herstellung kleinster planarer Cross-Point-Zellen als SONOS-Zellen angegeben, die in einer Common-Ground-NOR-Architektur verschaltet werden können. Jede Zelle wird über einen Bitleitungskontakt direkt mit der metallischen Bitleitung verbunden. Die Vorteile sind: Beanspruchung nur der kleinsten planaren Fläche (cross point cell), Möglichkeit des Fast-random-read-access, Möglichkeit der Optimierung der S/D-extensions der Speichertransistoren über LDD wie bei CMOS (wichtig für shrinkability), Möglichkeit niederohmiger Source-Leitungen, Kompatibilität des Speicherzellenaufbaus mit der Multi-Bit-Speicherung und geringer Zusatzaufwand im Vergleich zum Basis-Logik-Prozess. Die streifenförmigen Isolationsgräben in Verbindung mit den quer dazu abgeschiedenen, ebenfalls streifenförmigen Source-Leitungen, zu den Wortleitungen selbstjustierte Source-Leitungen, zu den Wortleitungen selbstjustierte Drain-Kontakte und eine Schichtfolge, die eine unzureichende Justierung der Drain-Kontakte in der Richtung der Wortleitungen toleriert, sind die besonders vorteilhaften Merkmale der erfindungsgemäßen Speicherzelle.

## Patentansprüche

1. Speicherzelle mit
- einem an einer Oberseite eines Halbleiterkörpers (1) ausgebildeten Source-Bereich (S) und einem Drain-Bereich (D),
- einer dazwischen auf dieser Oberseite angeordneten Gate-Elektrode (5,6),
- Zuführungen einer Source-Leitung, einer Drain-Leitung und einer Gate-Leitung und
- einer Speicherschichtstruktur aus einer ersten Begrenzungsschicht (2), einer zweiten Begrenzungsschicht (4) und einer dazwischen angeordneten Speicherschicht (3), die jeweils ein Material mit einer jeweiligen Energiebandlücke umfassen, wobei die Speicherschicht eine niedrigere Energiebandlücke besitzt als die Begrenzungsschichten,
**dadurch gekennzeichnet, dass**
- die Speicherschichtstruktur zwischen dem Halbleiterkörper und der Gate-Elektrode angeordnet ist,
- die Source-Leitung als gemeinsamer Source-Anschluss für mehrere Speicherzellen vorgesehen ist und den Source-Bereich zwischen der Gate-Elektrode und einer für eine weitere Speicherzelle vorgesehenen weiteren Gate-Elektrode kontaktiert,
- die Gate-Elektrode Teil der Gate-Leitung ist, die streifenförmig strukturiert ist und als Wortleitung vorgesehen ist, und
- die Drain-Leitung als metallische Leiterbahn ausgebildet ist, die mit dem Drain-Bereich elektrisch leitend verbunden ist und die quer zu der Gate-Leitung verlaufend und von der Gate-Leitung elektrisch isoliert als Bitleitung angeordnet ist.

2. Speicherzelle nach Anspruch 1,
die gegen weitere Speicherzellen, die beidseitig in Richtung der Gate-Leitung vorhanden sind, durch Isolationsgräben (STI) in dem Halbleiterkörper abgegrenzt ist.

3. Speicherzelle nach Anspruch 1 oder 2, bei der beidseitig des Source-Bereiches und des Drain-Bereiches je eine Gate-Elektrode vorhanden ist,
die Source-Leitung eine streifenförmige, leitfähig dotierte Polysiliziumschicht (17) ist, die über dem Source-Bereich den Bereich zwischen den Gate-Elektroden auffüllt,
eine weitere streifenförmige, leitfähig dotierte Polysiliziumschicht (17) vorhanden ist, die über dem Drain-Bereich den Bereich zwischen den Gate-Elektroden auffüllt und mit der metallischen Drain-Leitung (23) kontaktiert ist, und
zwischen den Gate-Elektroden und den Polysiliziumschichten jeweils elektrisch isolierende Trennschichten angeordnet sind.

4. Speicherzelle nach Anspruch 3, bei der
zwischen der Polysiliziumschicht (17) über dem Source-Bereich (S) und der Polysiliziumschicht (17) über dem Drain-Bereich (D) nur eine Gate-Elektrode (5, 6), die für diese Speicherzelle vorgesehen ist, vorhanden ist.

5. Speicherzelle nach Anspruch 3, bei der
zwischen der Polysiliziumschicht (17) über dem Source-Bereich (S) und der Polysiliziumschicht (17) über dem Drain-Bereich (D) eine Gate-Elektrode, die für diese Speicherzelle vorgesehen ist, und eine über einen weiteren Source-/Drain-Bereich damit in Reihe angeordnete weitere Gate-Elektrode, die als Select-Gate-Elektrode vorgesehen ist, angeordnet ist.

6. Speicherzelle nach einem der Ansprüche 1 bis 5, bei der sich an den Source-Bereich und an den Drain-Bereich zu einer jeweils benachbarten Gate-Elektrode hin ein LDD-Bereich mit einer gegenüber dem Source-Bereich bzw. dem Drain-Bereich reduzierten Dotierstoffkonzentration anschließt.

7. Speicherzelle nach einem der Ansprüche 1 bis 6, bei der die Speicherschicht Siliziumnitrid ist und die Begrenzungsschichten Siliziumoxid sind.

8. Speicherzelle nach einem der Ansprüche 1 bis 6, bei der die Speicherschicht Tantaloxid oder Hafniumsilikat ist und die Begrenzungsschichten Siliziumoxid sind.

9. Speicherzelle nach einem der Ansprüche 1 bis 6, bei der die Speicherschicht Hafniumoxid oder Hafniumsilikat oder Zirkonoxid oder Zirkonsilikat enthält und die Begrenzungsschichten Aluminiumoxid oder aluminiumhaltiges Siliziumoxid sind.

10. Speicherzelle nach einem der Ansprüche 1 bis 9, bei der die Gate-Elektrode durch eine leitfähig dotierte Polysiliziumschicht (5) und eine darauf aufgebrachte metallhaltige Schicht (6) oder Schichtfolge gebildet ist.

11. Speicherzelle nach Anspruch 10, bei der
die metallhaltige Schicht (6) ein Metallsilizid oder eine Doppelschicht aus einem Metallnitrid und einer reinen Metallschicht ist.

12. Speicherzelle nach Anspruch 11, bei der
die metallhaltige Schicht (6) Wolframsilizid oder eine Doppelschicht aus Wolframnitrid und Wolfram ist.

13. Speicherzelle nach einem der Ansprüche 1 bis 12, bei der die erste Begrenzungsschicht (2) der Speicherschichtstruktur eine Oxidschicht und 2,5 nm bis 8 nm dick ist,
die zweite Begrenzungsschicht (4) der Speicherschichtstruktur eine Oxidschicht und 3 nm bis 12 nm dick ist und die Speicherschicht (3) 1 nm bis 5 nm dick ist.

14. Speicherzelle nach einem der Ansprüche 1 bis 13, bei der die Drain-Leitung (23) eine Schichtfolge aus in der Richtung zunehmenden Abstandes von dem Drain-Bereich Titan, Titannitrid und Wolfram oder Tantal, Tantalnitrid und Kupfer ist.

15. Verfahren zur Herstellung einer Speicherzellenanordnung, bei dem
in einem ersten Schritt in einem mit einer vorgesehenen Dotierung versehenen Halbleiterkörper (1) eine Anzahl streifenförmiger, geradlinig parallel in einem Abstand zueinander verlaufender Isolationsgräben (STI) hergestellt wird,
in einem zweiten Schritt eine Schichtfolge aus einer ersten Begrenzungsschicht (2), einer Speicherschicht (3) und einer zweiten Begrenzungsschicht (4), die jeweils ein Material mit einer jeweiligen Energiebandlücke umfassen, sowie einer leitfähig dotierten Polysiliziumschicht (5), mindestens einer metallhaltigen Schicht (6) und einer Nitridschicht (7) aufgebracht wird, wobei die Speicherschicht mit einer niedrigeren Energiebandlücke hergestellt wird als die Begrenzungsschichten,
in einem dritten Schritt diese Schichtfolge zumindest bis zu der Speicherschicht (3) reichend in streifenförmige Anteile strukturiert wird, die geradlinig parallel in einem Abstand zueinander quer zu den Isolationsgräben (STI) verlaufen,
in einem vierten Schritt eine weitere Nitridschicht (9) ganzflächig aufgebracht wird,
in einem fünften Schritt zwischen die streifenförmigen Anteile der Schichtfolge eine Implantation (31, 32) von Dotierstoff zur Ausbildung von LDD-Bereichen vorgenommen wird,
in einem sechsten Schritt Distanzelemente (12) an den Seiten der streifenförmigen Anteile der Schichtfolge hergestellt werden,
in einem siebten Schritt in Bereiche zwischen den Distanzelementen eine Implantation (33) von Dotierstoff zur Ausbildung von Source- und Drain-Bereichen vorgenommen wird,
in einem achten Schritt die Zwischenräume zwischen den streifenförmigen Anteilen der Schichtfolge mit elektrisch isolierendem Material (13, 14, 15) gefüllt werden und unter Verwendung einer Maske dieses isolierende Material in Bereichen, die zum Anschluss der Source- und Drain-Bereiche vorgesehen sind, im Wesentlichen entfernt wird, wobei jedenfalls das isolierende Material zwischen den Drain-Bereichen über den Isolationsgräben (STI) stehen bleibt,
vor oder nach dem achten Schritt die weitere Nitridschicht (9) in offenen Bereichen zwischen den Distanzelementen (12) entfernt wird und die Distanzelemente entfernt werden, in einem neunten Schritt die in dem achten Schritt von dem isolierenden Material freigelegten Bereiche mit einer elektrisch leitfähig dotierten Polysiliziumschicht (17) gefüllt werden,
in einem zehnten Schritt außerhalb der über den Drain-Bereichen (D) vorhandenen Anteile der Polysiliziumschicht (17) eine Dielektrikumschicht (20) hergestellt wird und
in einem elften Schritt metallische Drain-Leitungen (23) aufgebracht und quer zu den streifenförmigen Anteilen der Schichtfolge streifenförmig strukturiert werden, so dass sie jeweils mit den auf einer Geraden aufeinander folgenden und mit der Polysiliziumschicht (17) kontaktierten Drain-Bereichen (D) elektrisch leitend verbunden sind.

16. Verfahren nach Anspruch 15, bei dem
in dem achten Schritt in einer fortlaufenden Nummerierung der streifenförmigen Anteile der Schichtfolge das isolierende Material jeweils zwischen einem geradzahlig nummerierten Anteil und dem darauf folgenden ungeradzahlig nummerierten Anteil zur Ausbildung von isolierten Source-/Drain-Bereichen zwischen einem jeweiligen Ansteuer-Gate und einem Select-Gate stehen gelassen wird.

17. Verfahren nach Anspruch 15 oder 16, bei dem
in dem achten Schritt das eingebrachte isolierende Material jeweils zwischen zwei streifenförmigen Anteilen der Schichtfolge, zwischen denen Source-Bereiche vorhanden sind, die für einen Anschluss an die in dem neunten Schritt aufgebrachte Polysiliziumschicht (17) vorgesehen sind, zur Ausbildung von Source-Leitungen, die jeweils mit den auf einer Geraden aufeinander folgenden Source-Bereichen (S) elektrisch leitend verbunden sind, vollständig entfernt wird.

18. Verfahren nach einem der Ansprüche 15 bis 17, bei dem
in dem zweiten Schritt die mindestens eine metallhaltige Schicht (6) ein Metallsilizid oder eine Doppelschicht aus einem Metallnitrid und einer reinen Metallschicht ist.

19. Verfahren nach Anspruch 18, bei der
die mindestens eine metallhaltige Schicht (6) Wolframsilizid oder eine Doppelschicht aus Wolframnitrid und Wolfram ist.
